Europäisches Patentamt

European Patent Office

Office européen des brevets

(11) Veröffentlichungsnummer: **0 607 787 A2**

# (12) EUROPÄISCHE PATENTANMELDUNG

(21) Anmeldenummer: **94100038.2**

(22) Anmeldetag: **04.01.94**

(51) Int. Cl.5: **H01J 37/32**

(30) Priorität: **19.01.93 DE 4301188**

(43) Veröffentlichungstag der Anmeldung:
**27.07.94 Patentblatt 94/30**

(84) Benannte Vertragsstaaten:
**DE FR NL**

(71) Anmelder: **LEYBOLD AKTIENGESELLSCHAFT**
**Wilhelm-Rohn-Strasse 25,**
**Postfach 1555**
**D-63450 Hanau(DE)**

(72) Erfinder: **Arnold, Manfred**
**Rebleweiher 6**
**D-88074 Meckenbeuren(DE)**
Erfinder: **Blang, Guido**
**Albert-Einstein-Strasse 1**
**D-64569 Nauheim(DE)**
Erfinder: **Gegenwart, Rainer**
**Bruchwiesenstrasse 69 a**
**D-63322 Rödermark(DE)**
Erfinder: **Ritter, Jochen**
**Grünes Meer 16**
**D-35321 Laubach(DE)**
Erfinder: **Stoll, Helmut**
**Eschborner Strasse 22**
**D-63834 Sulzbach(DE)**

(74) Vertreter: **Schickedanz, Willi, Dipl.-Ing.**
**Langener Strasse 68**
**D-63073 Offenbach (DE)**

(54) **Vorrichtung zum Beschichten oder Ätzen von Substraten.**

(57) Die Erfindung betrifft eine Vorrichtung zum Beschichten oder Ätzen von Substraten. Bei dieser Vorrichtung wird berührungslos eine HF-Substrat-Vorspannung erzeugt. Dazu werden Plasmaquellen mit einem Bias-Topf ausgerüstet, der im Dunkelraumabstand zu einem Substratträger angeordnet ist und mit HF beaufschlagt wird. Je nach verwendeter Quelle kann der Bias-Topf als eigenständige Einheit oder als leitend verbundener Bestandteil der Quelle - z. B. HF-Magnetron - aufgebaut sein. Über diese eingekoppelte HF-Leistung kann das DC-Potential am Carrier und damit der Ionenbeschuß am Substrat gezielt eingestellt werden.

EP 0 607 787 A2

Die Erfindung betrifft eine Vorrichtung zum Beschichten oder Ätzen von Substraten nach dem Oberbegriff des Patentanspruchs 1.

Bei zahlreichen Ätz- und Beschichtungsprozessen werden Plasmen erzeugt, aus denen Ionen auf ein Substrat hin beschleunigt werden. Um die Dikke einer Beschichtung oder die Tiefe einer Ätzung steuern zu können, ist eine Gleichspannung zwischen zwei Elektroden vorgesehen, die ein Plasma einschließen.

Sollen elektrisch nicht leitende Schichten auf einem Substrat aufgebracht werden, so muß anstelle einer Gleichspannung eine Wechselspannung angelegt werden, um ein Gleichstrompotential am Substrat aufzubauen, das für die Beschleunigung von geladenen Teilchen, insbesondere von Ionen, in Richtung auf das Substrat erforderlich ist.

Wesentlich für den Beschichtungs- oder Ätzeffekt ist die Ausbildung eines stationären Potentialunterschieds zwischen Plasma und Elektrode, der bei einer an der Elektrode anliegenden HF-Spannung dadurch erreicht wird, daß während der positiven Halbperiode wesentlich mehr Elektronen in die Elektrodenoberfläche als während der negativen Halbperiode positive Ionen entströmen können. Da aber im zeitlichen Mittel gleich viele positive und negative Ladungsträger aus dem Plasma abgeführt werden, lädt sich die Elektrode so weit negativ gegen das Plasma auf, bis nahezu während der ganzen Periodendauer positive Ionen einströmen können. Vor den Elektroden entstehen positive Raumladungsgebiete, die zu einem Gleichrichtereffekt und zur Ausbildung einer Sperrschichtkapazität führen (vgl. DE-PS 37 08 717, Spalte 5, Zeile 20 bis Spalte 6, Zeile 6).

Es sind bereits zahlreiche Beschichtungsanlagen mit Wechselstromzuführungen an Elektroden bekannt, die einen Plasmaraum einschließen (US-PS 3 461 054, US-PS 4 874 494, US-PS 4 719 154, US-PS 4 424 101, US-PS 3 767 551, US-PS 3 617 459, US-PS 4 572 842; F. Vratny: Deposition of Tantalum and Tantalum Oxide by Superimposed RF and D-C Sputtering, J. Electrochem. Soc., Vol. 114, No. 5, May 1967, S. 506, Fig. 1; EP-A-0 347 567; K. Köhler, J. W. Coburn, D. E. Horne, E. Kay: Plasma potentials of 13.56 MHz rf argon glow discharges in a planar system, J. Appl. Phys. 51-(1), Januar 1985, S. 59 - 66; Butler und Kino: Plasma Sheath Formation by Radio-Frequency Fields, The Physics of Fluids, Vol. 6, No. 9, Sept. 1963, S. 1346 bis 1355; A. J. van Roosmalen, W. G. M. van den Hoek und H. Kalter: Electrical properties of planar rf discharges for dry etching, J. Appl. Phys. 58, Juli 1985, S. 653 bis 658; EP-PS 0 470 580). Diese Anlagen sind jedoch nicht für einen sogenannten In-line-Betrieb geeignet, bei dem nacheinander mehrere Substrate an einer Elektrode vorbeigeführt werden.

Weiterhin ist eine Vorrichtung bekannt, in der zu beschichtende Substrate innerhalb eines Rezipienten bewegt werden (DE-OS 29 09 804). Die Hochfrequenzspannung für die Erzeugung eines Plasmas wird hierbei über Leitungen an einen Substrathalter und an einen Targethalter gelegt. Einzelheiten über die Anordnung und Halterung des Substrats sind nicht gezeigt.

Ferner ist ein Plasmareaktor bekannt, bei dem sich eine erste und eine zweite Elektrode gegenüberliegen und wobei eine dritte Elektrode zwischen der ersten und der zweiten Elektrode vorgesehen ist (EP-A-0 139 835). Die erste Elektrode liegt hierbei an Erdpotential, während die zweite Elektrode an einer Wechselspannung von etwa 100 kHz liegt und die dritte Elektrode mit einer Wechselspannung von 13,56 MHz versorgt wird. Diejenige Elektrode, die zwischen den beiden anderen Elektroden angeordnet ist, hat hierbei die Form eines Rings. Ein In-line-Betrieb ist jedoch mit diesem Plasmareaktor ebenfalls nicht möglich, weil das zu beschichtende Substrat auf der zweiten Elektrode ortsfest angeordnet ist.

Weiterhin ist eine Vorrichtung zum Ätzen von Substraten durch eine Glimmentladung bekannt, bei welcher die einem Substratträger gegenüberliegende Elektrode in der Randzone mit einem auf gleichem Potential liegenden Vorsprung versehen ist, der den Raum zwischen der Elektrode und dem Substrat bzw. dem Substratträger bis auf einen Spalt von etwa 5 mm überbrückt, derart, daß die Glimmentladung auf den Raum zwischen Substratträger und Elektrode begrenzbar ist (DE-PS 22 41 229). Diese bekannte Vorrichtung ist indessen wegen einer geschlossenen Glocke über einem Substratträger und wegen der ortsfesten Anordnung dieses Substratträgers nicht für eine In-line-Anlage geeignet. Außerdem ist eine HF-Substrat-Biasspannung nicht einstellbar.

Für eine andere bekannte Vorrichtung ist zur Vermeidung von unerwünschten Effekten durch Glimmentladungen vorgeschlagen worden, das Verhältnis der Fläche der mit Spannung versorgten Elektrode zu der Fläche aller anderen Oberflächen, die mit der Entladung in Kontakt stehen, zu minimieren und eine möglichst große Vakuumkammer zu verwenden, damit die Kanten der Elektrode weit genug von den Kammerwänden entfernt sind (J. L. Vossen, Glow Discharge Phenomena in Plasma Etching and Plasma Deposition, J. Electrochem. Soc. SSST, Bd. 126, 1979, S. 319 bis 324). Eine Möglichkeit für die Realisierung einer In-line-Anlage ist aber auch bei dieser Vorrichtung nicht gezeigt.

Um bei einer dynamischen Beschichtung in In-Line-Systemen, bei welchen die Substrate durch ein Transportsystem während der Beschichtung an der Beschichtungsquelle vorbeigeführt werden, die Hochfrequenzspannung an die Elektroden legen zu können, wäre es denkbar, diese über einen Schleif- oder Rollenkontakt galvanisch einzukoppeln. Hierbei würden jedoch im Bereich der Spannungseinkopplung parasitäre Plasmen auftreten, die nur durch eine technisch aufwendige Dunkelraumab-schirmung des Transportsystems unterdrückt wer-den könnten. Außerdem würden die Schleif- oder Rollenkontakte mit der Zeit beschichtet, was sich insbesondere dann, wenn die Beschichtung aus einem elektrischen Isolator besteht, negativ auf die Leistungsübertragung auswirken würde. Hinzu kommt, daß die bei der Verwendung von Schleifkontakten oder Kontaktrollen auftretende starke mechanische Belastung die Erzeugung von Partikeln fördert, die ihrerseits die Schichtqualität mindern.

Der Erfindung liegt die Aufgabe zugrunde, in einer HF-Plasmaanordnung, bei der das zu bearbeitende Substrat an einer Elektrode vorbeigeführt wird, eine Gleichstrom-Bias-Spannung zu erzeugen, die für die Beschleunigung geladener Teilchen zum Substrat hin geeignet ist.

Diese Aufgabe wird gemäß den Merkmalen des Patentanspruchs 1 gelöst.

Der mit der Erfindung erzielte Vorteil besteht insbesondere darin, daß für die Erzeugung einer Bias-Spannung im In-Line-Betrieb keine galvanische Kontaktierung über Antriebsrollen des Substratträgers erforderlich ist.

Ausführungsbeispiele der Erfindung sind in der Zeichnung dargestellt und werden im folgenden näher beschrieben. Es zeigen:

Fig. 1 eine Plasmakammer, in der ein Substrat an einer Elektrode vorbeigeführt wird;

Fig. 2 eine weitere Plasmakammer mit beweglichem Substrat, bei welcher das Plasma in größerer Entfernung vom Substrat angeregt wird.

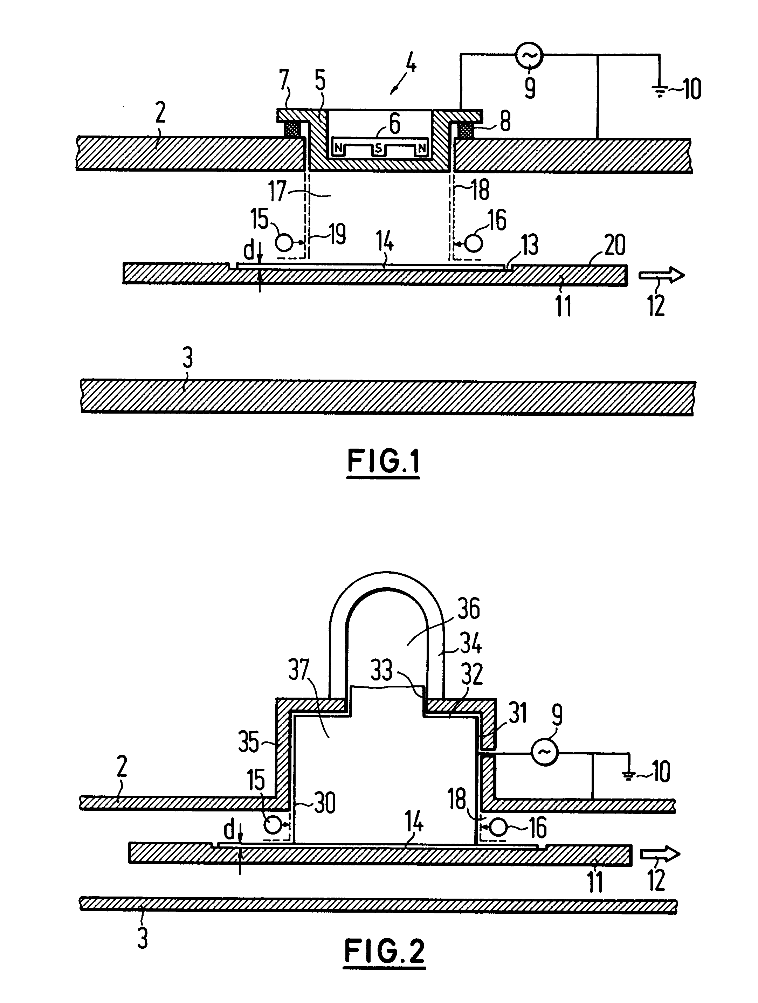

In der Fig. 1 ist eine Plasmakammer 1 mit einer oberen und einer unteren Kammerwand 2 bzw. 3 dargestellt, wobei die untere Kammerwand 3 auf Erdpotential liegt. Die Kammerwände können sich dabei sehr weit nach rechts und links erstrekken, bis sie dann schließlich durch nicht dargestellte vertikale Wände abgeschlossen werden. In die obere Wand 2 ist ein Magnetron 4 eingepaßt, das aus einer Elektrodenwanne 5 und einem dreipoligen Dauermagneten 6 besteht. Die Elektrodenwanne 5 weist einen oberen Kragen 7 auf, der auf einer Dichtung 8 aufsitzt, die auf der oberen Wand 2 liegt. An die Elektrodenwanne 5 ist der eine An-schluß einer Wechselspannungsquelle 9 ange-schlossen, die beispielsweise eine Spannung von 13,56 MHz abgibt. Der andere Anschluß der Wechselspannungsquelle 9 liegt - wie auch die Wand 2 - an Erde 10.

Zwischen der oberen Wand 2 und der unteren Wand 3 ist ein Träger 11 angeordnet, der linear und parallel zu den Wänden 2,3 bewegt werden kann, was durch einen Pfeil 12 symbolisiert ist. In einer Vertiefung 13 dieses Trägers 11 befindet sich ein zu beschichtendes oder zu ätzendes Substrat 14.

Zwischen der oberen Wand 2 und dem Träger 11 bzw. dem Substrat 14 sind Gaseinlaßrohre 15, 16 vorgesehen. Diese Gaseinlaßrohre 15, 16 befinden sich außerhalb des Beschichtungsraums 17 im engeren Sinn, der von einem zylindrischen Gitter 18 umgeben ist, das auch einen Bias-Topf 19 einschließt, der elektrisch mit der Elektrode 5 verbunden ist.

Die Gaszufuhr erfolgt somit auch in der Vakuumkammer, sie ist jedoch vom Plasmaraum 17 durch eine geerdete Elektrode 18 getrennt. Hierdurch wird eine Beschichtung der Gaseinlaßrohre 15, 16 verhindert.

Der Bias-Topf 19 besteht z. B. ebenfalls aus einem Gitter, das bis auf einen Dunkelraumabstand d an die Oberfläche des Substrats 14 herangeführt ist. Da die Oberfläche des Substrats 14 mit der Oberfläche 20 des Trägers 11 außerhalb der Vertiefung 13 fluchtet, hält der Bias-Topf 19 auch zu dieser Oberfläche 20 einen Abstand d. Bei einem Druck von einigen $10^{-3}$ mbar sollte der Abstand d im Bereich von einigen Millimetern liegen. Unter einem Dunkelraumabstand wird hierbei der Abstand verstanden, der bei einer Glimmentladung zwischen der Kathode mit dem negativen Glimmlicht liegt. Dieser sogenannte Kathodendunkelraum ist durch einen starken Spannungsanstieg gekennzeichnet. Das den Bias-Topf 19 umgebende Gitter 18 ist an Masse bzw. Erde gelegt. Hierdurch wird verhindert, daß außerhalb des Plasmaraums 17 parasitäre Plasmen gezündet werden.

Würde nur ein Bias-Topf 19 ohne Gitter 18 vorgesehen, so würde ein Plasma vom Bias-Topf 19 zu den Wänden der Vakuumkammer zünden.

Der Bias-Topf 19 muß nicht mit der Elektrode 5 elektrisch verbunden sein. Vielmehr kann er von der Elektrode getrennt werden. Wird er mechanisch und elektrisch an die Elektrode 5 angeschlossen und zusammen mit der Elektrode 5 mit der Spannung der Spannungsquelle 9 beaufschlagt, so können Plasmaparameter und die Biasspannung nicht mehr getrennt voneinander eingestellt werden.

Die Plasmazone 17 ist räumlich durch die Elektrode 5, den Bias-Topf 19 und das Substrat 14 definiert. Im Plasma bildet sich ein positives Plasmapotential aus, das zur Elektrode 5 und zum Bias-Topf 19 bzw. zum Substrat 14 stark abfällt. Dadurch erfahren die im Plasma vorhandenen positiven Ionen eine vom Potential der Elektrode 5 abhängige Beschleunigung. Die Elektrodenpotentiale sind gemäß der Beziehung

$$\frac{U_{BPT}}{U_{Substrat}} = \left(\frac{F_{Substrat}}{F_{BPT}}\right)^n$$

mit n = 1-4

vom Verhältnis der Elektrodenflächen abhängig. Führt man den Bias-Topf 19 geometrisch so aus, daß seine Fläche groß ist im Vergleich zur effektiven Fläche des Substratträgers 11, so erhält man das größere Potential am Substratträger, verglichen mit dem zum Plasmapotential negativen Elektrodenpotential. Hierbei wird lediglich derjenige Teil des Substratträgers 11 einbezogen, der unmittelbar dem Plasma ausgesetzt und durch die Öffnung des Bias-Topfs 19 definiert ist.

Bei einer solchen Anordnung werden Ionen auf das Substrat 14 geschossen, deren Energie durch den Potentialunterschied zwischen Substratträger 11 und Plasma festgelegt wird. Das absolute Potential, das auf Erde bzw. Plasma 10 bezogen ist, spielt dabei keine Rolle, weil es nur auf die Potentialdifferenz ankommt. So kann z. B. auch der Substratträger 11 geerdet sein. In diesem Fall stellt sich auf der Oberfläche des Bias-Topfs 19, die dann die größere Oberfläche ist, ein relativ zur Masse positives Potential ein. Noch höher positiv ist das Plasmapotential, so daß auch hier eine Beschleunigung der Ionen zum Substrat 14 hin erfolgt.

Die HF-Substrat-Biasspannungen und damit indirekt die Energie des Ionenbeschusses des Substrats 14 sind folglich über die geometrische Ausführung des Bias-Topfs 19 und über die Leistung der an den Bias-Topf 19 angelegten Hochfrequenz einstellbar.

In der Fig. 2 ist eine Variante der in der Fig. 1 gezeigten Vorrichtung dargestellt, bei der diejenigen Bauteile, die Bauteilen der Vorrichtung gemäß Fig. 1 entsprechen, dieselben Bezugszahlen aufweisen. Der Bias-Topf 30 ist bei dieser Vorrichtung nicht als Gitter, sondern als geschlossener Topf ausgebildet, der nicht nur eine zylindrische Außenfläche 31, sondern auch einen Boden 32 mit einem Öffnungsstutzen 33 aufweist. Dieser Öffnungsstutzen 33 ragt in eine entfernte kuppelförmige Plasmaquelle 34 hinein, deren Aufbau nicht im einzelnen dargestellt ist. Die Spannung der HF-Spannungsquelle 9 wird dabei direkt an den Bias-Topf 30 gelegt. Das Gitter 18, welches den Bias-Topf 30 umgibt, ist hierbei wesentlich niedriger als im Falle des Ausführungsbeispiels der Fig. 1, weil sich die obere Wand 2 mit einer topfförmigen Ausstülpung 35 nach oben erstreckt. Das Gesamtvolumen, in dem ein Plasma vorhanden ist und das aus den beiden Volumina 36 und 37 besteht, ist größer als der Raum 17 in Fig. 1.

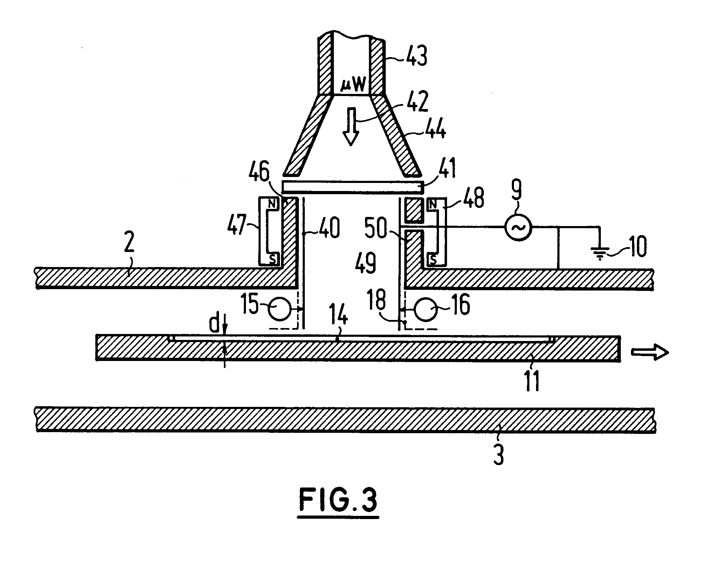

Die Fig. 3 zeigt eine Variante, bei der eine Mikrowelle eingespeist wird, um ein Plasma zu erzeugen. Der Bias-Topf ist hierbei mit 40 bezeichnet und befindet sich unterhalb eines Quarzfensters 41, durch das eine Mikrowelle 42 gelangt, die aus einem Hohlleiter 43 und einem nachgeschalteten Hornstrahler 44 kommt. Die obere Wand 2 geht in einen hohlen Stutzen 46 über, der den größten Teil des Bias-Topfs 40 aufnimmt. In demjenigen Bereich, in dem der Bias-Topf nicht von dem Stutzen 46 umschlossen ist, ist das Gitter 18 vorgesehen. Um den Stutzen 46 herum sind Dauermagnete 47, 48 angeordnet, die ein cusp-förmiges Magnetfeld in den Raum 49 geben, der den Bias-Topf 40 einhüllt. die Hochfrequenzquelle 9 ist wieder mit ihrem einen Anschluß an den Bias-Topf 40 gelegt, während ihr anderer Anschluß an Masse bzw. Erde 10 liegt.

**Patentansprüche**

1. Vorrichtung zum Beschichten oder Ätzen von Substraten mit

1.1 einer Prozeßkammer (1), die wenigstens eine obere Begrenzungswand (2) und eine untere Begrenzungswand (3) aufweist;

1.2 einem zwischen der oberen und der unteren Begrenzungswand (2, 3) angeordneten Träger (11);

1.3 einem Substrat (14), das auf der Oberseite des Trägers angeordnet ist;

1.4 einer plasmaerzeugenden Vorrichtung (4; 34; 43, 44) an der oberen Begrenzungswand (2) der Prozeßkammer,

**dadurch gekennzeichnet**, daß

1.5 der Träger (11) in bezug auf die Begrenzungswände (2, 3) verschiebbar ist, 1.6 zwischen Träger (11) und oberer Begrenzungswand (2) Gaszuführungen (15, 16) angeordnet sind,

1.7 der Raum zwischen der plasmaerzeugenden Vorrichtung (4; 34; 43, 44) und bis dicht über dem Substrat (14) bzw. dem Träger (11) von einem Vorspannungs-Topf (19, 30, 40) umgeben ist,

1.7.1 wobei der von dem Vorspannungs-Topf (19, 30, 40) eingeschlossene Raum nur Plasma enthält und

1.7.2 wobei der Abstand zwischen dem unteren Rand des Vorspannungs-Topfs (19, 30, 40) und der Oberfläche des Substrats (14) bzw. des Trägers (11) kleiner als der Dunkelraumabstand ist,

1.8 eine Spannungsquelle (9) vorgesehen ist, die mit dem Vorspannungs-Topf (19, 30, 40) in elektrischer Verbindung steht.

**2.** Vorrichtung nach Anspruch 1, **dadurch gekennzeichnet**, daß der Vorspannungs-Topf (30) durch ein zylindrisches Metallgitter (19) gebildet ist.

**3.** Vorrichtung nach Anspruch 1, **dadurch gekennzeichnet**, daß der Vorspannungs-Topf (30) aus einem Zylindermantel aus Metall besteht.

**4.** Vorrichtung nach Anspruch 1, **dadurch gekennzeichnet**, daß das Substrat (14) auf einem Träger (11) angeordnet ist, der an der Kammer (17, 37, 49) vorbeibewegt werden kann.

**5.** Vorrichtung nach Anspruch 1, **dadurch gekennzeichnet**, daß ein Prozeßraum vorgesehen ist, der durch eine obere und eine untere Wand (2, 3) abgeschlossen ist, wobei sich zwischen beiden Wänden der Träger (11) mit dem Substrat (14) befindet.

**6.** Vorrichtung nach Anspruch 1 und Anspruch 5, **dadurch gekennzeichnet**, daß zwischen Träger (11) und oberer Wand (2) wenigstens ein Gaseinlaß (15, 16) vorgesehen ist.

**7.** Vorrichtung nach Anspruch 1, **dadurch gekennzeichnet**, daß die Plasmakammer (17) in ihrem oberen Bereich ein Magnetron (4) aufweist.

**8.** Vorrichtung nach Anspruch 1, **dadurch gekennzeichnet**, daß die Plasmakammer (37) eine entfernte Plasmaquelle (36) aufweist.

**9.** Vorrichtung nach Anspruch 1, **dadurch gekennzeichnet**, daß die Kammer (49) mit einer Mikrowelleneinstrahlung (43, 44) in Verbindung steht.

**10.** Vorrichtung nach Anspruch 8, **dadurch gekennzeichnet**, daß die obere Wand (2) der Prozeßkammer eine Ausstülpung (35) aufweist, die den größeren Bereich des Vorspannungs-Topfs (30) umschließt.

**11.** Vorrichtung nach Anspruch 9, **dadurch gekennzeichnet**, daß die obere Wand (2) der Prozeßkammer eine Ausstülpung (50) aufweist, welche den größeren Bereich des Vorspannungs-Topfs (40) umschließt, wobei an der Außenwand der Ausstülpung Dauermagnete (47, 48) vorgesehen sind.

**12.** Vorrichtung nach Anspruch 1, **dadurch gekennzeichnet**, daß die Spannungsquelle eine Wechselspannungsquelle mit einer Frequenz in der Größenordnung von 13,56 MHz ist.

**FIG.1**

**FIG.2**

**FIG.3**